# EUROPÄISCHE PATENTSCHRIFT

(11) **EP 2 921 035 B1**
(45) Veröffentlichungstag und Bekanntmachung des Hinweises auf die Patenterteilung: **02.11.2016**
(21) Anmeldenummer: 13753605.8
(22) Anmeldetag: 20.08.2013
(51) Int. Cl.: H05K 1/02, H05K 1/18

(54) **REFLEKTORANORDNUNG**
REFLECTOR ARRANGEMENT
SYSTÈME DE RÉFLECTEUR

(30) Priorität: 16.11.2012 DE 102012220977
(43) Veröffentlichungstag der Anmeldung: 23.09.2015
(73) Patentinhaber: OSRAM GmbH, 80807 München (DE)
(72) Erfinder: REINGRUBER, Fabian, 80796 München (DE); KLEEMANN, Bernhard, 86343 Königsbrunn (DE)
(86) Internationale Anmeldenummer: PCT/EP2013/067315
(87) Internationale Veröffentlichungsnummer: WO 2014/075826

(56) Entgegenhaltungen:
- WO-A1-2012/127355
- US-A1- 2005 094 392

## Beschreibung

### Technisches Gebiet

Die Erfindung geht aus von einer Reflektoranordnung nach dem Oberbegriff des Patentanspruchs 1.

### Stand der Technik

Aus dem Stand der Technik sind Reflektoranordnungen mit an einem Grundkörper angeordneten LED-Leiterplatten und daran angeordneten Reflektoren bekannt.

Beispielsweise zeigen US 2005/094392 A1 und WO 2012/127355 A1 eine Anordnung mit einem Grundkörper, einer LED-Leiterplatte und mindestens einem Reflektor.

Um LED-Leuchten beispielsweise als Büroleute verwenden zu können, müssen bestimmte Richtlinien und Normen eingehalten werden, wie beispielsweise Normen zur Einhaltung der Bildschirmarbeitsplatztauglichkeit. Dementsprechend sind u.a. bestimmte Anforderungen an die seitliche Entblendung der LED-Leuchten zu stellen. Um diesen Anforderungen gerecht werden zu können und eine bestimmte Abstrahlcharakteristik einer solchen Leuchte zu erreichen, sind bestimmte Optiken oder Reflektoren erforderlich. Das Hauptproblem jedoch bei der Verwendung von Reflektoren oder Reflektorrastern ist dabei die Positionierung eines solchen Reflektors über den LEDs. Bei einer derartigen Positionierung müssen vorgeschriebene Sicherheitsabstände gewährleistet werden und zum anderen muss die Positionierung auch derart akkurat sein, dass sich keine negativen Einflüsse auf die Abstrahlcharakteristik ergeben. Dabei ergeben sich weitere Probleme, wie die unterschiedliche thermische Ausdehnung der einzelnen Materialien sowie Ungenauigkeiten in der Anordnung bedingt durch Fertigungstoleranzen, denen ebenfalls Rechnung getragen werden muss.

### Darstellung der Erfindung

Die Aufgabe der vorliegenden Erfindung ist es, eine Reflektoranordnung bereitzustellen, welche eine Positionierung eines Reflektors in möglichst akkurater Weise ermöglicht.

Diese Aufgabe wird gelöst durch eine Reflektoranordnung mit den Merkmalen des Patentanspruchs 1.

Besonders vorteilhafte Ausgestaltungen finden sich in den abhängigen Ansprüchen.

Die erfindungsgemäße Reflektoranordnung umfasst einen Grundkörper, welcher einen Aufnahmebereich zur Aufnahme mindestens einer LED-Leiterplatte aufweist, mindestens eine LED-Leiterplatte, welche im Aufnahmebereich des Grundkörpers angeordnet ist und mindestens eine Aussparung aufweist, und mindestens ein Reflektorelement, welches ein erstes Verbindungselement aufweist. Des Weiteren umfasst die Reflektoranordnung mindestens ein Fixierelement mit einer Ober- und einer Unterseite, wobei die Oberseite in einem Abstand zur Unterseite angeordnet ist, und wobei die Unterseite ein zweites Verbindungselement aufweist, das eine Längserstreckung in einer Längserstreckungsrichtung in Richtung von der Oberseite zur Unterseite aufweist. Weiterhin weist die Oberseite des Fixierelements eine Vertiefung in der Längserstreckungsrichtung auf. Dabei sind das zweite Verbindungselement des Fixierelements und die Aussparung der LED-Leiterplatte derart ausgebildet, dass das zweite Verbindungselement in die Aussparung der LED-Leiterplatte einführbar ist, so dass die Unterseite des Fixierelements mit der Leiterplatte kontaktierbar ist. Weiterhin sind die Vertiefung der Oberseite des Fixierelements und das erste Verbindungselement des Reflektorelement derart ausgebildet, dass in die Vertiefung der Oberseite des Fixierelements das erste Verbindungselement des Reflektorelements einführbar ist, so dass das Reflektorelement mit der Oberseite des Fixierelements kontaktierbar ist.

Durch das Fixierelement der erfindungsgemäße Reflektoranordnung wird es somit zum einen ermöglicht, einen vorgegebenen Abstand zwischen einem Reflektorelement und einer LED-Leiterplatte einzuhalten. Das Fixierelement kann dabei beispielsweise so ausgebildet sein, dass der Abstand zwischen seiner Ober- und seiner Unterseite mit vorgegebenen Normen konform ist. Darüber hinaus kann durch das Fixierelement ein Reflektorelement an einer LED-Leiterplatte an einer definierten Stelle fixiert werden. So wird durch das Fixierelement eine Positionierung eines Reflektorelements in äußerst akkurater Weise ermöglicht. Das Fixierelement hat aber darüber hinaus noch eine Vielzahl an weiteren Vorteilen. Es muss nicht zwingend ein erstes Verbindungselement eines Reflektorelements in die Vertiefung des Fixierelements eingeführt werden, ein Reflektorelement kann auch an einer Stelle auf die Oberseite des Fixierelement auflegbar sein, so dass an dieser Stelle durch das Fixierelement ein Abstand zur LED-Leiterplatte vorgegeben ist, und das Reflektorelement an dieser aufgelegten Stelle zumindest in einer Richtung beweglich ist. Bei Verwendung mehrerer Fixierelement kann so beispielsweise ermöglicht werden, dass das Reflektorelement mittels eines Fixierelements fixierbar ist und an einer weiteren Stelle auf ein weiteres Fixierelement auflegbar ist, so dass unterschiedlichen Fertigungstoleranzen oder thermischen Ausdehnungen Rechnung getragen werden kann. Das Fixierelement der erfindungsgemäßen Reflektoranordnung hat im Gegensatz zu beispielsweise einstückig mit einem Reflektorelement ausgebildeten Abstandselementen zudem den Vorteil, dass eine Ausrichtung des Fixierelements unabhängig vom Reflektorelement möglich ist. Dies stellt weitere sehr vorteilhafte Möglichkeiten der Positionierung und Fixierung bereit, welche nachfolgend noch näher erläutert werden.

Bei einer vorteilhaften Ausgestaltung der Erfindung weist das zweite Verbindungselement an der Unterseite des Fixierelements eine zylinderförmige Grundform auf, und die Aussparung der LED-Leiterplatte ist derart zylinderförmig ausgebildet, dass das Fixierelement bei in die Aussparung der LED-Leiterplatte eingeführtem zweiten Verbindungselement um eine in Richtung der Längserstreckungsrichtung verlaufende Achse drehbar ist.

Dies ermöglicht die Ausrichtung des Fixierelement in gewünschter Weise. Beispielsweise kann die Vertiefung des Fixierelements so ausgestaltet sein, dass ein Einführen des ersten Verbindungselements des Reflektorelements nur möglich ist, wenn diese eine bestimmte Winkelstellung zueinander aufweisen, um durch das Fixierelement eine Ausrichtung des Reflektorelements zu ermöglichen. Durch Drehbarkeit des Fixierelements in der zylinderförmigen Aussparung der LED-Leiterplatte kann so eine entsprechende Ausrichtung wesentlich einfacher und akkurater vorgenommen werden als beispielsweise durch Drehung des Reflektorelements selbst.

Bei einer weiteren vorteilhaften Ausgestaltung der Erfindung weist das Fixierelement eine Außenseite auf, welche zwischen der Oberseite und der Unterseite des Fixierelements angeordnet ist, wobei an der Außenseite ein hakenförmiges Verbindungsstück angeordnet ist. Weiterhin weist der Grundkörper mindestens ein Gegenstückelement auf, das derart ausgebildet ist, dass das hakenförmige Verbindungsstück in das Gegenstückelement einhakbar ist.

Durch das hakenförmige Verbindungsstück kann so eine zusätzliche seitliche Fixierung des Fixierelements erfolgen. Insbesondere wird durch die Möglichkeit des Einhakens in ein Gegenstückelement ein zusätzlicher Fixierpunkt des Fixierelements bereitgestellt, was eine noch genauere und stabilere Ausrichtung des Fixierelements und somit auch des Reflektorelements ermöglicht. Des Weiteren wird so die Möglichkeit bereitgestellt, auch die LED-Leiterplatte zu fixieren. Wenn also beispielsweise die LED-Leiterplatte nicht fest am Grundkörper befestigt ist, sondern in den Aufnahmebereich des Grundkörpers lediglich eingelegt oder eingeschoben ist, so kann durch das Fixierelement, insbesondere durch ein Einführen des ersten Verbindungselements in die Aussparung der LED-Leiterplatte und durch ein Einhaken des hakenförmigen Verbindungselements des Fixierelements in das Gegenstückelement des Grundkörpers auch gleichzeitig ein Befestigen bzw. Fixieren der LED-Leiterplatte am Grundkörper bewerkstelligt werden.

Bei einer weiteren vorteilhaften Ausgestaltung der Erfindung ist das Gegenstückelement des Grundkörpers zumindest zum Teil entlang des Aufnahmebereichs der LED-Leiterplatte angeordnet. Dabei ist das Gegenstückelement bevorzugt derart ausgebildet, dass das hakenförmige Verbindungsstück des Fixierelements bei in die Aussparung der LED-Leiterplatte eingeführtem zweiten Verbindungselement der Unterseite des Fixierelements durch Drehung des Fixierelements um die in Richtung der Längserstreckungsrichtung verlaufende Achse in das Gegenstückelement einhakbar ist. Dies stellt eine besonders einfach zu handhabende Möglichkeit dar, das Fixierelement in das Gegenstückelement einzuhaken. Insbesondere bei einer erstrebenswerten möglichst kompakten Ausbildung der Reflektoranordnung ist auch das Fixierelement relativ klein gehalten, so dass das Einhaken durch Drehung des Fixierelements eine besonders elegante Befestigungs- und Justagemöglicheit des Fixierelements darstellt.

Des Weiteren können die Vertiefung der Oberseite des Fixierelements und das erste Verbindungselement des Reflektorelements in einem Querschnitt senkrecht zur Längserstreckungsrichtung rund ausgebildet sein, so dass das Reflektorelement bei in die Vertiefung eingeführtem ersten Verbindungselement um eine in Richtung der Längserstreckungsrichtung verlaufende Achse drehbar ist.

Dies erlaubt zumindest in gewissem Rahmen eine vom Fixierelement unabhängige Drehung des Reflektorelements, wie beispielsweise für eine Feinjustage der Positionierung. Darüber hinaus erlaubt diese Ausbildung der Vertiefung eine Drehung des Fixierelements mittels eines geeigneten Werkzeugs, welches beispielsweise einer Negativform der Vertiefung entsprechen kann, wie z.B. einem flachen Schraubendreher mit aufgesetztem Zylinder, Kegel oder Kegelstumpf. Darüber hinaus kann das erste Verbindungselement des Reflektorelements als Indexzylinder ausgebildet sein, so dass bei einem Einführen diese Zylinders in die Vertiefung das Reflektorelement so weit drehbar ist bis der Index oder die Indizes in vorgesehene Einkerbungen bzw. Aussparungen der Vertiefung des Fixierelements einrasten.

Bei einer weiteren vorteilhaften Ausgestaltung der Erfindung weist die Oberseite des Fixierelements eine gradlinige Nut senkrecht zur Längserstreckungsrichtung auf, und das Reflektorelement weist ein Schlittenelement auf, das derart ausgebildet ist, dass es in die Nut einführbar ist.

Durch diese Nut wird eine präzise Ausrichtung des Reflektorelements ermöglicht. Insbesondere kann durch die Möglichkeit der Einführung des Schlittenelements des Reflektorelements eine Fixierung senkrecht zur Nut vorgenommen werden, während das Schlittenelement und somit auch das Reflektorelement in Richtung der Nut beweglich sind. So kann auf besonders vorteilhafte Weise eine Fixierung des Reflektorelements an der LED-Platine an einer bestimmten Stelle durch beispielsweise ein erstes Fixierelement bewerkstelligt werden und durch das Vorsehen eines weiteren solchen Fixierelements kann der Reflektor in einer Richtung senkrecht zur Nut ausgerichtet und fixiert werden. Durch die Beweglichkeit des Reflektorelement in Richtung der Nut können bei der Positionierung des Reflektorelements auch Fertigungstoleranzen und unterschiedlichen thermischen Ausdehnungen, insbesondere des Reflektorelements, Rechnung getragen werden.

Bei einer weiteren vorteilhaften Ausgestaltung der Erfindung ist die Außenseite des Fixierelements mindestens in einem Bereich als ebene Fläche ausgebildet, so dass das Fixierelement mittels dieser ebenen Fläche am Gegenstückelement des Grundkörpers ausrichtbar ist.

Diese ebene Fläche kann dabei am beispielsweise geradlinig ausgebildeten Gegenstückelement des Grundkörpers bei in die Aussparung der LED-Leiterplatte eingeführtem zweiten Verbindungselement des Fixierelements anliegen. Weiterhin kann beispielsweise die Nut der Oberseite des Fixierelements parallel zur dieser ebenen Fläche der Außenseite verlaufen, so dass das Reflektorelement mit dem in die Nut einführbaren Schlittenelement ebenfalls parallel zum Gegenstückelement ausgerichtet werden kann. Dabei sollte die Aussparung der LED-Leiterplatte derart in der Leiterplatte positioniert sein, dass die Aussparung einen derartigen Abstand zum Gegenstückelement des Grundkörpers aufweist, dass die ebene Fläche der Außenseite des Fixierelements bei in die Aussparung der LED-Leiterplatte eingeführtem zweiten Verbindungselement das Gegenstückelement des Grundkörpers kontaktiert. Insbesondere kann es vorgesehen sein, dass Fixierelemente, welche zur Führung des Schlittenelements des Reflektorelements mittels der Nut verwendet werden, derart mit dem zweiten Verbindungselement in der Aussparung der LED-Leiterplatte anordenbar sind, dass sie, bedingt durch die Kontaktierung ihrer ebenen Fläche mit dem Gegenstückelement des Grundkörpers, nicht drehbar sind, und dass Fixierelemente, die zur Einführung des zweiten Verbindungselements des Reflektorelements verwendet werden sollen, drehbar sind. Dies kann beispielsweise dadurch bewerkstelligt werden, dass diese bei in die Aussparung der LED-Leiterplatte eingeführtem zweiten Verbindungselement einen größeren Abstand zum Gegenstückelement des Grundkörpers aufweisen, so dass sie diesen nicht kontaktieren, oder bevorzugt wird dies so bewerkstelligt, dass das Gegenstückelement eine, insbesondere kreissegmentförmigen, Aussparung in Form eines Index aufweist, insbesondere in dem Bereich des Gegenstückelements, wo das hakenförmige Verbindungsstück des Fixierelements durch Drehung des Fixierelements in das Gegenstückelement einhakbar sein soll.

Bei einer weiteren vorteilhaften Ausgestaltung der Erfindung ist an der Außenseite des Fixierelements ein Anschlagelement angeordnet, mittels welchem das Fixierelement bei in die Aussparung der LED-Leiterplatte eingeführtem zweiten Verbindungselement bis zu einer vorgebbaren Position drehbar ist.

Die Außenseite des Fixierelements kann dabei beispielsweise im Wesentlichen rund ausgestaltet sein mit einer in einem Bereich angeordneten ebenen Fläche, wie oben beschrieben, und dem Anschlagelement, das beispielsweise als eine Erhebung aus der Außenseite ausgebildet ist. Damit kann das Fixierelement in die Aussparung der LED-Leiterplatte eingeführt werden und anschließend zum Einhaken des hakenförmigen Verbindungselements in das Gegenstückelement des Grundkörpers gedreht werden bis das Anschlagelement das Gegenstückelement kontaktiert und somit ein Weiterdrehen des Fixierelements verhindert. So kann das Fixierelement sehr präzise genau so weit gedreht werden bis die eingehakte Position eingenommen ist.

Bei einer weiteren vorteilhaften Ausgestaltung der Erfindung umfasst das Reflektorelement Abstandselemente mit einer vorgegebenen Länge in der Längserstreckungsrichtung, so dass bei in die Vertiefung der Oberseite des Fixierelements eingeführtem ersten Verbindungselement des Reflektorelements und bei in die Aussparung der LED-Leiterplatte eingeführtem zweiten Verbindungselement des Fixierelements die Abstandselemente die LED-Leiterplatte kontaktieren. Die Abstandselemente sind dabei bevorzugt so angeordnet, dass sie bei einem Kontaktieren der LED-Leiterplatte diese in Bereichen kontaktieren, in welchen keine Leiterbahnen verlaufen. Durch die Abstandselemente kann so eine zusätzliche Stützfunktion erreicht werden. Insbesondere ist durch das Fixierelement eine präzise Positionierung und Fixierung des Reflektorelements bereits gegeben, so dass ein Abstützen des Reflektorelements an weiteren Stellen mittels einfach ausgebildeten Abstandselementen bewerkstelligt werden kann.

Bei einer weiteren Ausgestaltung der Erfindung umfasst das Reflektorelement Schnappelemente, welche dazu ausgebildet sind, bei an der LED-Leiterplatte angeordnetem Reflektorelement unter Anlageflächen des Grundkörpers, welche zumindest zum Teil entlang des Aufnahmebereichs der LED-Leiterplatte angeordnet sind einzuschnappen. Diese Schnappelemente ermöglichen eine zusätzliche Halterung, Stabilisierung und/oder Fixierung des Reflektorelements am Grundkörper. Die Schnappelemente können dabei als Schnapphacken ausgebildet sein, die unter die beidseitig am Aufnahmebereich angeordneten Anlageflächen einschnappen. Die Anlageflächen können dabei auch mit den Gegenstückelementen des Grundkörpers identisch sein, welche insbesondere schienenförmig beidseitig entlang des Aufnahmebereichs des Grundkörpers verlaufen können. Durch das Einschnappen kann so eine mechanische Verriegelung des Reflektorelements am Grundkörper bewerkstelligt werden.

So zeigt sich auch hier der große Vorteil eines separaten Fixierelements, denn durch das Aufsetzen und Einführen des zweiten Verbindungselements in die Vertiefung des Fixierelements wird bereits vor dem Einschnappen der Schnappelemente eine Positionierung des Reflektorelements vorgenommen und diese Positionierung durch das vollständige Einführen und das damit einhergehende Einschnappen der Schnappelemente endgültig fixiert. Ohne das Fixierelement wäre also eine Vorab-Positionierung des Reflektorelements gar nicht möglich und nach Einschnappen der Schnappelemente wäre das Reflektorelement fest fixiert, so dass keine nachträgliche Ausrichtung, Positionierung oder Verschiebung mehr möglich wäre.

Weitere Vorteile, Merkmale und Einzelheiten der Erfindung ergeben sich aus den Ansprüchen, der nachfolgenden Beschreibung bevorzugter Ausführungsformen sowie anhand der Zeichnungen.

### Kurze Beschreibung der Zeichnungen

Im Folgenden soll die Erfindung anhand von Ausführungsbeispielen näher erläutert werden. Die Figuren zeigen:
- Fig. 1: eine schematische Darstellung einer auf einem Grundkörper angeordneten LED-Leiterplatte für eine Reflektoranordnung gemäß einem Ausführungsbeispiel der Erfindung;
- Fig. 2a: eine schematische Darstellung einer ersten perspektivischen Ansicht eines Fixierelements für eine Reflektoranordnung gemäß einem Ausführungsbeispiel der Erfindung;
- Fig. 2b: eine schematische Darstellung einer zweiten perspektivischen Ansicht des Fixierelements aus Fig. 2a;
- Fig. 3a: eine schematische Darstellung eines an der LED-Leiterplatte und dem Grundkörper angeordnetem Fixierelements für eine Reflektoranordnung gemäß einem Ausführungsbeispiel der Erfindung;
- Fig. 3b: eine weitere Ansicht der schematischen Darstellung aus Fig. 3a in einem Querschnitt durch das Fixierelement;
- Fig. 4: eine schematische Darstellung zweier auf der LED-Leiterplatte angeordneter Fixierelemente in unterschiedlicher Positionierung für eine Reflektoranordnung gemäß einem Ausführungsbeispiel der Erfindung;
- Fig. 5a: eine schematische Darstellung einer Draufsicht auf ein Reflektorelement für eine Reflektoranordnung gemäß einem Ausführungsbeispiel der Erfindung;
- Fig. 5b: eine schematische Darstellung einer Unteransicht eines Reflektorelements für eine Reflektoranordnung gemäß einem Ausführungsbeispiel der Erfindung;
- Fig. 6: eine schematische Darstellung eines Querschnitts durch eine Reflektoranordnung mit einem gleichzeitigen Querschnitt durch ein Fixierelement, in welches das erste Verbindungselement des Reflektorelements eingeführt ist, gemäß einem Ausführungsbeispiel der Erfindung;
- Fig. 7: eine weitere schematische Darstellung eines Querschnitts durch eine Reflektoranordnung mit einem gleichzeitigen Querschnitt durch ein Fixierelement, in dessen Nut das Schlittenelement des Reflektorelements eingeführt ist, gemäß einem Ausführungsbeispiel der Erfindung;
- Fig. 8: eine weitere schematische Darstellung eines Querschnitts durch eine Reflektoranordnung mit einem am Reflektorelement angeordneten Abstandselement gemäß einem Ausführungsbeispiel der Erfindung; und
- Fig. 9: eine schematische Darstellung einer Reflektoranordnung mit einer Mehrzahl an LED-Leiterplatten und einer Mehrzahl an Reflektorelementen gemäß einem Ausführungsbeispiel der Erfindung.

### Bevorzugte Ausführung der Erfindung

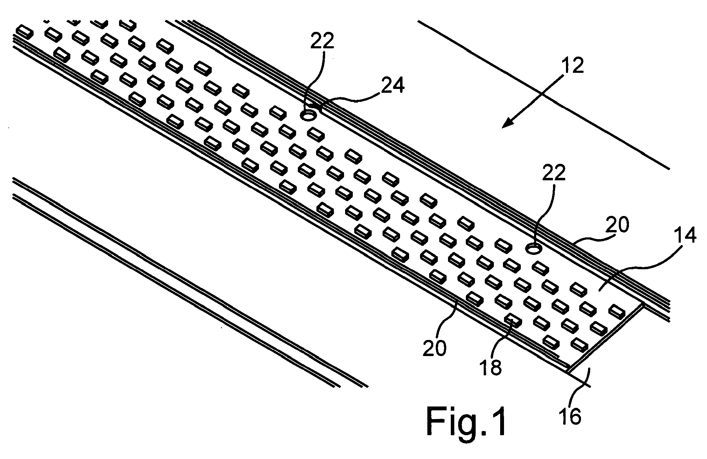

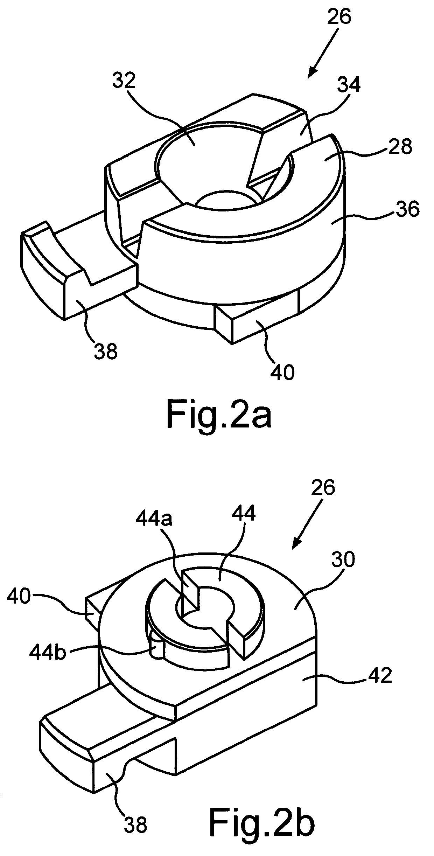

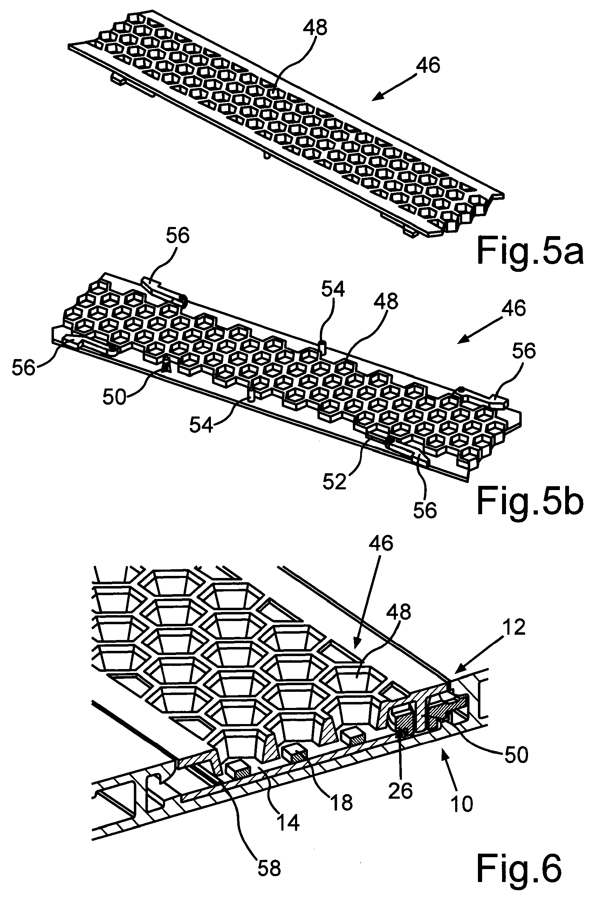

Fig. 1 zeigt eine schematische Darstellung einer auf einem Grundkörper 12 angeordneten LED-Leiterplatte 14 für eine Reflektoranordnung 10 (vgl. Fig. 6-8) gemäß einem Ausführungsbeispiel der Erfindung. Der Grundkörper 12 weist dabei einen Aufnahmebereich 16 auf, in welchem die LED-Leiterplatte 14 angeordnet ist. Der Aufnahmebereich 16 kann dabei als Vertiefung in der Grundkörperoberfläche ausgebildet sein. Auf der LED-Leiterplatte 14 ist eine Mehrzahl an LEDs 18 angeordnet, an denen jeweils ein Einzelreflektor 48 (vgl. Fig. 5a) angeordnet werden soll. Entlang des Aufnahmebereichs 16 sind seitlich und geradlinig Gegenstückelemente 20 angeordnet, welche beispielsweise schienenartig ausgebildet sein können. Die LED-Leiterplatte 14 weist hier zwei Aussparungen 22 auf, in welchen Fixierelemente 26 (vgl. Fig. 2a) angeordnet werden können. Diese beiden Aussparungen 22 weisen dabei bevorzugt den gleichen Abstand zum Rand des Aufnahmebereichs 16 auf, also insbesondere zu dem am Rand verlaufenden Gegenstückelement 20. Im Bereich einer Aussparung 22, in der hier links dargestellten, ist im Rand des Aufnahmebereichs 16 bzw. im Gegenstückelement 20 ein Index 24 in Form einer kreissegmentartigen Aussparung eingebracht. Dieser Index 24 dient dazu, dass ein Fixierelement 26 bei in die Aussparung 22 der LED-Leiterplatte 14 eingeführtem zweiten Verbindungselement 44 drehbar ist, während ein in die rechte Aussparung 22 eingebrachtes Fixierelement 26 nicht drehbar ist.

Fig. 2a zeigt eine schematische Darstellung einer ersten perspektivischen Ansicht eines Fixierelements 26 für eine Reflektoranordnung 10 gemäß einem Ausführungsbeispiel der Erfindung. Das Fixierelement 26 ist hier als Drehriegel ausgebildet und weist insbesondere eine Oberseite 28 und eine Unterseite 30 (vgl. Fig. 2b) auf. Die Oberseite 28 hat dabei eine Vertiefung 32, welche hier kegelstumpfförmig ausgebildet ist mit einer zylinderförmigen Fortsetzung in Längserstreckungsrichtung. Als Längserstreckungsrichtung wird hierbei die Richtung von der Oberseite 28 des Fixierelements 26 zur Unterseite 30 bezeichnet. Des Weiteren weist die Oberseite 28 des Fixierelements 26 eine geradlinige Nut 34 auf. Diese verläuft in diesem Beispiel zentral durch die Vertiefung 32, kann aber im Allgemeinen auch an anderer Stelle verlaufen. Weiterhin ist an der Außenseite 36 des Fixierelements 26 ein hakenförmiges Verbindungsstück 38 angeordnet zum Eingreifen in ein Gegenstückelement 20 des Grundkörpers 12. Darüber hinaus ist an der Außenseite 36 noch ein Anschlagelement 40 angeordnet, das an der im Wesentlichen zylinderförmigen Außenseite 36 hervorsteht. Die Außenseite 36 des Fixierelements 26 ist dabei insofern im Wesentlichen zylinderförmig als sie in einem Bereich eine als ebene Fläche 42 ausgebildete Seite aufweist (vgl. Fig. 2b).

Fig. 2b zeigt eine schematische Darstellung einer zweiten perspektivischen Ansicht des Fixierelement 26 aus Fig. 2a. Insbesondere ist diese Darstellung um 180° gegenüber der aus Fig. 2a gedreht. Das Fixierelement 26 umfasst dabei die gleichen Elemente wie in Fig. 2a beschrieben. Zusätzlich ist hier das zweite Verbindungselement 44 an der Unterseite 30 des Fixierelements 26 zu erkennen. Dieses ist bevorzugt zylinderförmig ausgebildet, um in eine zylinderförmige Aussparung 22 der LED-Leiterplatte 14 einführbar zu sein. Dabei kann das zweite Verbindungselement 44 auch aus Zylinderelementen, wie beispielsweise zwei Halbzylindern, gebildet sein und Aussparungen 44a und/oder Erhebungen 44b aufweisen, um beispielsweise bei entsprechender Ausbildung der Aussparung 22 der LED-Leiterplatte 14 ein Einrasten in eine Rastposition zu ermöglichen.

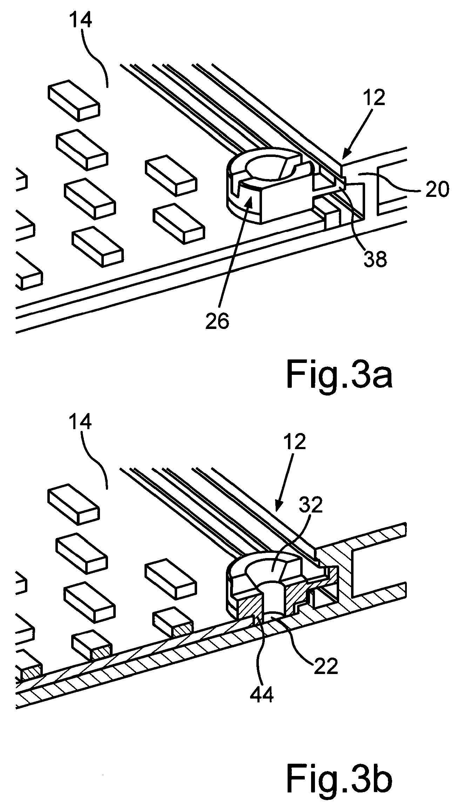

Fig. 3a zeigt eine schematische Darstellung eines an der LED-Leiterplatte 14 und dem Grundkörper 12 angeordnetem Fixierelements 26 für eine Reflektoranordnung 10 gemäß einem Ausführungsbeispiel der Erfindung. Gut zu erkennen ist hierbei der als Vertiefung des Grundkörpers 12 ausgebildete Aufnahmebereich 16 für die LED-Leiterplatte 14 und das schienenförmig ausgebildete Gegenstückelement 20, welches geradlinig und seitlich am Rand des Aufnahmebereichs 16 verläuft. Das hier dargestellt Fixierelement 26 befindet sich in einer eingehakten Position. Dabei greift das an der Außenseite 36 des Fixierelements 26 angeordnete hakenförmige Verbindungsstück 38 in das Gegenstückelement 20 des Grundkörpers 12. Weiterhin ist das Fixierelement 26 mit seinem zweiten Verbindungselement 44 in die Aussparung 22 der LED-Leiterplatte 14 eingeführt und zwar in eine Aussparung 22 wie sie in Fig. 1 links dargestellt ist, mit einem im Gegenstückelement 20 angeordneten kreissegmentförmigen Index 24. So kann das Fixierelement 26 zunächst in die Aussparung 22 der LED-Leiterplatte 14 eingeführt werden, wobei der Index 24 dafür sogt, dass das Fixierelement 26 nicht am Gegenstückelement 20 anliegt oder dieses kontaktiert und somit das Fixierelement 26 gedreht werden kann, insbesondere um eine entlang der Längserstreckungsrichtung verlaufenden Achse. Durch Drehung dieses Fixierelements 26 kann das hakenförmige Verbindungsstück 38 in das Gegenstückelement 20 eingehakt werden und in die wie in Fig. 3a dargestellte Position gebracht werden. Darüber hinaus sorgt das Anschlagelement 40 des Fixierelements 26 dafür, dass diese Position sehr präzise eingenommen werden kann. Durch dieses Einhaken des Fixierelement 26 wird zum einen eine äußerst präzise, feste und stabile Positionierung des Fixierelements 26 und somit dann auch des Reflektorelements 46 (vgl. Fig. 5a) ermöglicht, zum anderen wird aber auch auf besonders vorteilhafte Weise gleichzeitig eine Befestigung bzw. Fixierung der LED-Leiterplatte 14 ermöglicht. Denn durch das Eingreifen des zweiten Verbindungselements 44 des Fixierelements 26 in die Aussparung 22 der LED-Leiterplatte 14 und durch das gleichzeitige Einhaken des Fixierelements 26 in den Grundköper 12 ist nun die LED-Leiterplatte 14 fest am Grundkörper 12 befestigt.

Fig. 3b zeigt nochmal die in Fig. 3a dargestellte Anordnung in einem Querschnitt durch das Fixierelement 26. Hierbei ist zu erkennen, dass die Vertiefung 32 der Oberseite 28 des Fixierelements 26 auch als durchgängiges Loch ausgebildet sein kann, das sich von der Oberseite 28 bis zur Unterseite 30 erstreckt und fertigungstechnisch besonders einfach und kostengünstig ist. Darüber hinaus ist noch gut zu erkennen, wie die LED-Leiterplatte 14 zwischen dem Fixierelement 26 und dem Grundkörper12 eingeklemmt ist und somit am Grundkörper 12 fixiert ist.

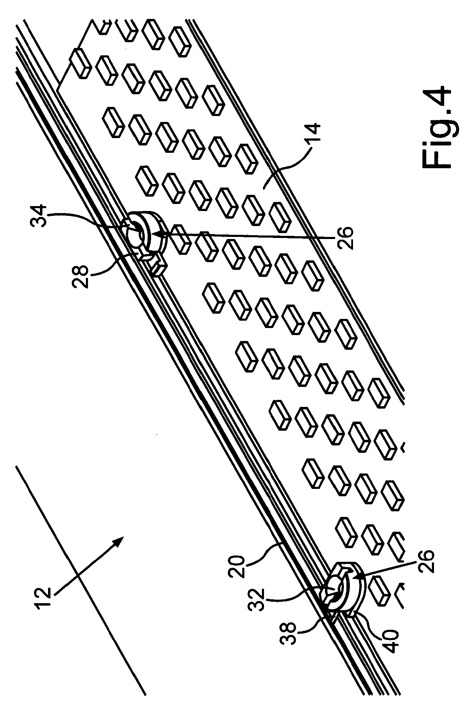

Fig. 4 zeigt eine schematische Darstellung zweier auf der LED-Leiterplatte 14 angeordneter Fixierelemente 26 in unterschiedlicher Positionierung für eine Reflektoranordnung 10 gemäß einem Ausführungsbeispiel der Erfindung. Die dargestellte Anordnung entspricht dabei der in Fig. 1 dargestellten Anordnung der LED-Leiterplatte 14 auf dem Grundkörper 12 mit nun in die beiden Aussparungen 22 der LED-Leiterplatte 14 eingeführten zweiten Verbindungselementen 44 der beiden dargestellten Fixierelemente 26.

In der linken Aussparung 22 ist das Fixierelement 26 derart positioniert, dass das hakenförmige Verbindungsstück 38 in das Gegenstückelement 20 des Grundkörpers 12 einhakt. Dies kann durch Einsetzen des Fixierelements 26 in die Aussparung 22 und Drehen des Fixierelements 26 in die eingehakte Position erfolgen. Die Drehung des Fixierelements 26 wird dabei durch den in Fig. 1 dargestellten Index 24 im Gegenstückelement 20 ermöglicht. Zur Präzisierung der Drehposition ist auch hierbei das Fixierelement 26 mit einem Anschlagelement 40 versehen. In die Vertiefung 32 des Fixierelement 26 kann das erste Verbindungselement 50 des Reflektorelements 46 eingeführt werden, wodurch ein Punkt des Reflektorelements 46 definiert, positioniert und fixiert ist.

In der rechten Aussparung 22 der LED-Leiterplatte 14 ist das Fixierelement 26 derart positioniert, dass die ebene Fläche 42 der Außenseite 36 des Fixierelements 26 am Gegenstückelement 20 anliegt. Die in der Oberseite 28 des Fixierelements 26 verlaufende Nut 34 ist dabei parallel zur ebenen Fläche 42 angeordnet und somit auch parallel zum Gegenstückelement 20. Diese Nut 34 ermöglicht die Aufnahme eines am Reflektorelement 46 angeordneten Schlittenelements 52, so dass das Reflektorelement 46 präzise parallel zum Gegenstückelement 20 ausgerichtet werden kann.

Diese beiden Fixierelemente 26 ermöglichen somit eine genaue Positionierung, Fixierung und Ausrichtung des Reflektorelements 46. Gleichzeitig können auch Fertigungstoleranzen oder die thermische Ausdehnung des Reflektorelements 46 berücksichtig werden, da dieser nur an einer Stelle, insbesondere durch das linke Fixierelement 26, in jeder Richtung fixierbar ist und durch das rechte Fixierelement 26 in einer Richtung entlang der Nut 34 verschiebbar ist.

Fig. 5a zeigt eine schematische Darstellung einer Draufsicht auf ein Reflektorelement 46 und Fig. 5b eine schematische Darstellung einer Unteransicht dieses Reflektorelements 46 für eine Reflektoranordnung 10 gemäß einem Ausführungsbeispiel der Erfindung. Das Reflektorelement 46 umfasst dabei eine Mehrzahl an Einzelreflektoren 48, welche insbesondere so angeordnet sind, das jedem Einzelreflektor 48 eine LED 18 der LED-Leiterplatte 14 zugeordnet ist. Die geometrische Ausgestaltung der Anordnung der Einzelreflektoren 48 ist also identisch mit der geometrischen Ausgestaltung der LED-Anordnung auf der LED-Leiterplatte 14. Das Reflektorelement 46 umfasst weiterhin, insbesondere an seiner Unterseite bzw. der Seite, die bei Anordnung an der LED-Leiterplatte 14 dieser zugewandt ist, ein erstes Verbindungselement 50, welches in die Vertiefung 32 eines Fixierelements 26 einführbar ist und in diesem Fall als Indexzylinder ausgebildet ist. Weiterhin weist das Reflektorelement 46 ein Schlittenelement 52 auf, um in die Nut 34 eines Fixierelements 26 zu greifen. Darüber hinaus sind noch Abstandselemente 54 am Reflektorelement 46 angeordnet, mittels welchen das Reflektorelement 46 bei Anordnung an der LED-Leiterplatte 14 auf dieser aufliegt. Darüber hinaus sind seitlich an der Unterseite des Reflektorelements 46 noch Schnappelemente 56 angeordnet, welche als Schnapphacken ausgebildet sind und bei Anordnen des Reflektorelements 46 an der LED-Leiterplatte 14 mit den Gegenstückelementen 20 des Grundkörpers 12 verschnappen können bzw. unter diesen einschnappen können und das Reflektorelement 46 somit am Grundkörper 12 mechanisch verriegeln können.

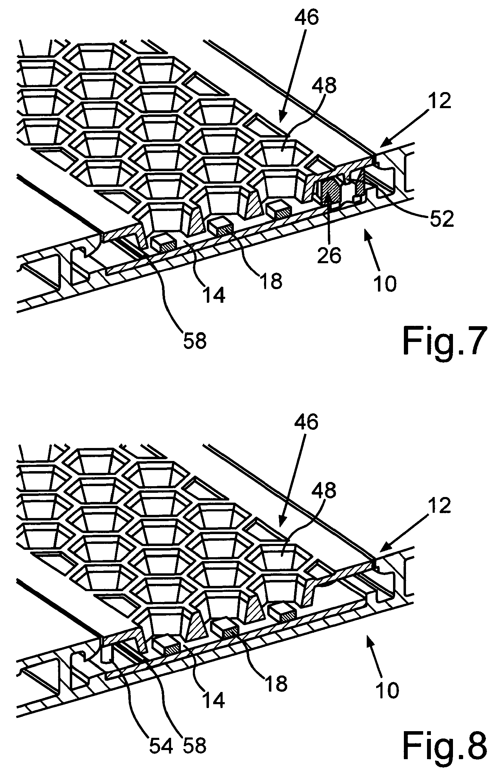

Fig. 6, Fig. 7 und Fig. 8 zeigen jeweils eine schematische Darstellung eines Querschnitts durch eine Reflektoranordnung 10 gemäß Ausführungsbeispielen der Erfindung. Hierbei ist nun das Reflektorelement 46 mittels der Fixierelemente 26 an der LED-Leiterplatte 14 fixiert und präzise positioniert, insbesondere so, dass jeder Einzelreflektor 48 möglichst genau über einer LED 18 in einem vorgegebenen und insbesondere durch die Fixierelemente 26 und Abstandselemente 54 bestimmten Abstand angeordnet ist. Fig. 6 zeigt dabei einen Querschnitt durch ein Fixierelement 26, in dessen Vertiefung 32 das erste Verbindungselement 50 des Reflektorelements 46 eingeführt ist, Fig. 7 zeigt einen Querschnitt durch ein Fixierelement 26, in dessen Nut 34 ein Schlittenelement 52 des Reflektorelements 46 eingeführt ist und Fig. 8 einen Querschnitt mit einem dargestellten Abstandselement 54 des Reflektorelements 46, um diesen zusätzlich gegenüber der LED-Leiterplatte 14 abzustützen und in einem vordefinierten Abstand zu halten. Die Fixierelemente 26 und die Abstandselemente 54 sind dabei so angeordnet, dass sie einen gewissen Abstand zu den auf der LED-Leiterplatte 14 verlaufenden Leiterbahnen 58 einhalten.

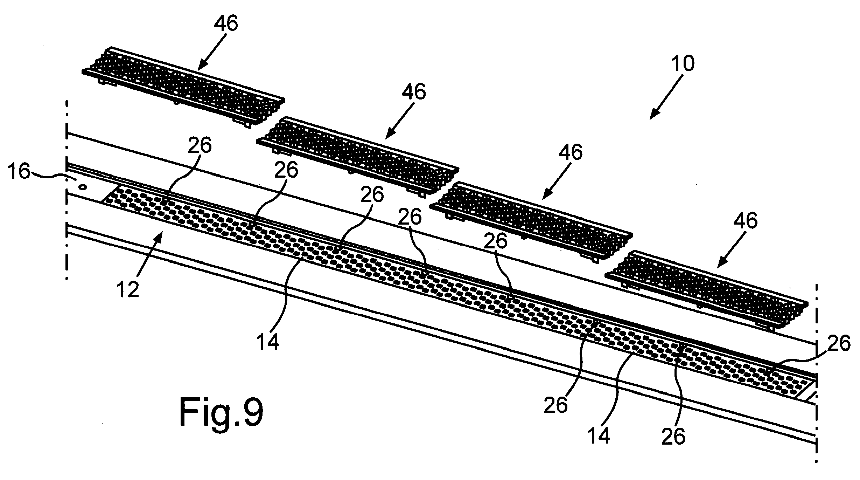

Fig. 9 zeigt eine schematische Darstellung einer Reflektoranordnung 10 mit einer Mehrzahl an LED-Leiterplatten 14, hier insbesondere zwei, und einer Mehrzahl an Reflektorelementen 46, hier insbesondere 4, gemäß einem Ausführungsbeispiel der Erfindung. Dabei weist der Grundkörper 12 einen Aufnahmebereich 16 auf, in welchem eine Mehrzahl an LED-Leiterplatten 14 angeordnet sind. Dabei sind in jeder LED-Leiterplatte 14 mehrere Fixierelemente 26 zur Positionierung der Reflektorelemente 46 angeordnet. Die Reflektorelemente 46 können somit auf die LED-Leiterplatten 14 aufgesteckt werden, und zwar bevorzugt so, dass ein erstes Verbindungselement 50 eines Reflektorelements 46 in eine Vertiefung 32 eines Fixierelements 26 eingeführt wird und das Schlittenelement 52 des Reflektorelements 46 in die Nut 34 eines weiteren Fixierelements 26 eingeführt wird. Insbesondere muss dabei nicht jedes Fixierelement 26 eine Nut 34 aufweisen, es kann auch beispielsweise nur jedes zweite Fixierelement 26 mit einer Nut 34 in der Oberseite 28 versehen sein. Der Grundköper 12 kann weiterhin ein stranggepresstes Aluminiumprofil sein und die Reflektorelemente 46 können metallisierte Kunststoff-Spritzgussteile sein. Diese Ausbildungen stellen besonders einfach zu fertigende und besonders kostengünstige Möglichkeiten dar.

Insgesamt wird so eine Reflektoranordnung bereitgestellt, welche eine Positionierung eines Reflektors gegenüber einer LED-Anordnung in äußerst akkurater Weise ermöglicht. So wird eine Positionierung ermöglicht, welche die vorgeschriebenen Sicherheitsabstände gewährleisten kann und derart akkurat ist, dass sich keine negativen Einflüsse auf die Abstrahlcharakteristik ergeben. Auch der thermisch unterschiedlichen Ausdehnung der einzelnen Materialien sowie der Fertigungstoleranzen kann durch diese Reflektoranordnung Rechnung getragen werden. All dies wird durch das Vorsehen eines Fixierelements ermöglicht, welches zwischen dem Reflektor und der LED-Leiterplatte angeordnet werden kann. Dieses Fixierelement kann zum einen dazu genutzt werden das Reflektorelement an einem definierten Punkt an der LED-Leiterplatte zu fixieren und gleichzeitig kann ein solches Fixierelement auch dazu verwendet werden das Reflektorelement auszurichten, so dass das Reflektorelement dennoch in einer Richtung beweglich bleibt um Fertigungstoleranzen und thermische Ausdehnungen abfangen zu können. Durch das Fixierelement kann auch gleichzeitig noch eine Fixierung der LED-Leiterplatte am Grundkörper ermöglicht werden. Die hier beschriebene Reflektoranordnung ermöglicht es die Position der Platinen und damit der LEDs gegenüber der Aufnahme und dem Reflektorelement zu definieren. Darüber hinaus kann die Reflektoranordnung zu geringen Kosten und mit geringem Montageaufwand umgesetzt werden. Des Weiteren lässt sich noch eine sehr geringe Bauhöhe und dadurch ein sehr flacher Leuchtenkörper realisieren.

## Patentansprüche

1. Reflektoranordnung (10) mit einem Grundkörper (12), mindestens einer LED-Leiterplatte (14) und mindestens einem Reflektorelement (46),
wobei
der Grundkörper (12) einen Aufnahmebereich (16) zur Aufnahme der mindestens einen LED-Leiterplatte (14) aufweist, wobei die mindestens eine LED-Leiterplatte (14) im Aufnahmebereich (16) des Grundkörpers (12) angeordnet ist und mindestens eine Aussparung (22) aufweist, wobei das Reflektorelement (46) ein erstes Verbindungselement (50) aufweist, **dadurch gekennzeichnet, dass** die Reflektoranordnung (10) mindestens ein Fixierelement (26) umfasst, wobei das Fixierelement (26) eine Oberseite (28) und eine Unterseite (30) umfasst, wobei die Oberseite (28) in einem Abstand zur Unterseite (30) angeordnet ist, wobei die Unterseite (30) ein zweites Verbindungselement (44) aufweist, das eine Längserstreckung in einer Längserstreckungsrichtung in Richtung von der Oberseite (28) zur Unterseite (30) aufweist, wobei die Oberseite (28) des Fixierelements (26) eine Vertiefung (32) in der Längserstreckungsrichtung aufweist, wobei das zweite Verbindungselement (44) des Fixierelements (26) und die Aussparung (22) der LED-Leiterplatte (14) derart ausgebildet sind, dass das zweite Verbindungselement (44) in die Aussparung (22) der LED-Leiterplatte (14) einführbar ist, so dass die Unterseite (30) des Fixierelements (26) mit der LED-Leiterplatte (14) kontaktierbar ist, und wobei die Vertiefung (32) der Oberseite (28) des Fixierelements (26) und das erste Verbindungselement (50) des Reflektorelements (46) derart ausgebildet sind, dass in die Vertiefung (32) der Oberseite (28) des Fixierelements (26) das erste Verbindungselement (50) des Reflektorelements (46) einführbar ist, so dass das Reflektorelement (46) mit der Oberseite (28) des Fixierelements (26) kontaktierbar ist.

2. Reflektoranordnung (10) nach Anspruch 1,
wobei das zweite Verbindungselement (44) an der Unterseite (30) des Fixierelements (26) eine zylinderförmige Grundform aufweist, und wobei die Aussparung (22) der LED-Leiterplatte (14) derart zylinderförmig ist, dass das Fixierelement (26) mit dem zweiten Verbindungselement (44) in einem in die Aussparung (22) der LED-Leiterplatte (14) eingeführten Zustand um eine in Richtung der Längserstreckungsrichtung verlaufende Achse drehbar ist.

3. Reflektoranordnung (10) nach einem der vorhergehenden Ansprüche,
wobei das Fixierelement (26) eine Außenseite (36) aufweist, welche zwischen der Oberseite (28) und der Unterseite (30) des Fixierelements (26) angeordnet ist, wobei an der Außenseite (36) ein hakenförmiges Verbindungsstück (38) angeordnet ist, wobei der Grundkörper (12) mindestens ein Gegenstückelement (20) aufweist, das derart ausgebildet ist, dass das hakenförmige Verbindungsstück (38) in das Gegenstückelement (20) einhakbar ist.

4. Reflektoranordnung (10) nach einem der vorhergehenden Ansprüche,
wobei das Gegenstückelement (20) zumindest zum Teil entlang des Aufnahmebereichs (16) der LED-Leiterplatte (14) angeordnet ist, wobei das Gegenstückelement (20) derart ausgebildet ist, dass das hakenförmige Verbindungsstück (38) des Fixierelements (26) bei in die Aussparung (22) der LED-Leiterplatte (14) eingeführtem zweiten Verbindungselement (44) der Unterseite (30) des Fixierelements (26) durch Drehung des Fixierelements (26) um die in Richtung der Längserstreckungsrichtung verlaufende Achse in das Gegenstückelement (20) einhakbar ist.

5. Reflektoranordnung (10) nach einem der vorhergehenden Ansprüche,
wobei die Vertiefung (32) der Oberseite (28) des Fixierelements (26) und das erste Verbindungselement (50) des Reflektorelements (46) in einem Querschnitt senkrecht zur Längserstreckungsrichtung rund ausgebildet sind, so dass das Reflektorelement (46) bei in die Vertiefung (32) eingeführtem ersten Verbindungselement (50) um eine in Richtung der Längserstreckungsrichtung verlaufende Achse drehbar ist.

6. Reflektoranordnung (10) nach einem der vorhergehenden Ansprüche,
wobei die Oberseite (28) des Fixierelements (26) eine gradlinige Nut (34) senkrecht zur Längserstreckungsrichtung aufweist, und wobei das Reflektorelement (46) ein Schlittenelement (52) aufweist, das derart ausgebildet ist, dass es in die Nut (34) einführbar ist.

7. Reflektoranordnung (10) nach einem der vorhergehenden Ansprüche,
wobei die Außenseite (36) des Fixierelements (26) mindestens in einem Bereich als ebene Fläche (42) ausgebildet ist, so dass das Fixierelement (26) mittels dieser ebenen Fläche (42) am Gegenstückelement (20) des Grundkörpers (12) ausrichtbar ist.

8. Reflektoranordnung nach einem der vorhergehenden Ansprüche,
wobei an der Außenseite (36) des Fixierelements (26) ein Anschlagelement (40) angeordnet ist, mittels welchem das Fixierelement (26) bei in die Aussparung (22) der LED-Leiterplatte (14) eingeführtem zweiten Verbindungselement (44) bis zu einer vorgebbaren Position drehbar ist.

9. Reflektoranordnung (10) nach einem der vorhergehenden Ansprüche,
wobei das Reflektorelement (46) Abstandselemente (54) mit einer vorgegebenen Länge in der Längserstreckungsrichtung aufweist, so dass bei in die Vertiefung (32) der Oberseite (28) des Fixierelements (26) eingeführtem ersten Verbindungselement (50) des Reflektorelements (46) und bei in die Aussparung (22) der LED-Leiterplatte (14) eingeführtem zweiten Verbindungselement (44) des Fixierelements (26) die Abstandselemente (54) die LED-Leiterplatte (14) kontaktieren.

10. Reflektoranordnung (10) nach einem der vorhergehenden Ansprüche,
wobei das Reflektorelement (46) Schnappelemente (56) umfasst, welche dazu ausgebildet sind, bei an der LED-Leiterplatte (14) angeordnetem Reflektorelement (46) unter Anlageflächen des Grundkörpers (12), welche zumindest zum Teil entlang des Aufnahmebereichs (16) der LED-Leiterplatte (14) angeordnet sind, einzuschnappen.

## Claims

1. Reflector arrangement (10) having a base (12), at least one LED circuit board (14) and at least one reflector element (46),
the base (12) having a holding area (16) for holding the at least one LED circuit board (14), the at least one LED circuit board (14) being arranged in the holding area (16) of the base (12) and having at least one recess (22), the reflector element (46) having a first connecting element (50),
**characterized in that** the reflector arrangement (10) comprises at least one fixing element (26), wherein the fixing element (26) comprises an upper side (28) and an underside (30), wherein the upper side (28) is arranged at a distance from the underside (30), wherein the underside (30) has a second connecting element (44), which has a longitudinal extent in a longitudinal direction from the upper side (28) to the underside (30), wherein the upper side (28) of the fixing element (26) has a depression (32) in the longitudinal direction, wherein the second connecting element (44) of the fixing element (26) and the recess (22) in the LED circuit board (14) are formed in such a way that the second connecting element (44) can be inserted into the recess (22) in the LED circuit board (14), so that the LED circuit board (14) can contact the underside (30) of the fixing element (26), and wherein the depression (32) in the upper side (28) of the fixing element (26) and the first connecting element (50) of the reflector element (46) are formed in such a way that the first connecting element (50) of the reflector element (46) can be inserted into the depression (32) in the upper side (28) of the fixing element (26), so that the upper side (28) of the fixing element (26) can contact the reflector element (46).

2. Reflector arrangement (10) according to Claim 1,
wherein the second connecting element (44) on the underside (30) of the fixing element (26) has a cylindrical basic shape, and wherein the recess (22) in the LED circuit board (14) is cylindrical in such a way that, with the second connecting element (44) in a state inserted into the recess (22) in the LED circuit board (44), the fixing element (26) can be rotated about an axis extending in the direction of the longitudinal extent.

3. Reflector arrangement (10) according to one of the preceding claims,
wherein the fixing element (26) has an outer side (36) which is arranged between the upper side (28) and the underside (30) of the fixing element (26), wherein a hook-shaped connecting piece (38) is arranged on the outer side (36), wherein the base (12) has at least one mating element (20), which is formed in such a way that the hook-shaped connecting piece (38) can be hooked into the mating element (20).

4. Reflector arrangement (10) according to one of the preceding claims,
wherein the mating element (20) is arranged at least partly along the holding area (16) of the LED circuit board (14), wherein the mating element (20) is formed in such a way that, when the second connecting element (44) of the underside (30) of the fixing element (26) is inserted into the recess (22) in the LED circuit board (14), the hook-shaped connecting piece (38) of the fixing element (26) can be hooked into the mating element (20) by rotating the fixing element (26) about the axis extending in the direction of the longitudinal extent.

5. Reflector arrangement (10) according to one of the preceding claims,
wherein the depression (32) in the upper side (28) of the fixing element (26) and the first connecting element (50) of the reflector element (46) are formed so as to be round in a cross section perpendicular to the longitudinal extent, so that, when the first connecting element (50) is inserted into the depression (32), the reflector element (46) can be rotated about an axis extending in the direction of the longitudinal extent.

6. Reflector arrangement (10) according to one of the preceding claims,
wherein the upper side (28) of the fixing element (26) has a rectilinear groove (34) perpendicular to the longitudinal extent, and wherein the reflector element (46) has a slide element (52), which is formed in such a way that it can be inserted into the groove (34).

7. Reflector arrangement (10) according to one of the preceding claims,
wherein the outer side (36) of the fixing element (26) is formed as a flat surface (42), at least in one area, so that the fixing element (26) can be aligned with this flat surface (42) on the mating element (20) of the base (12).

8. Reflector arrangement according to one of the preceding claims,
wherein, on the outer side (36) of the fixing element (26), there is arranged a stop element (40), by means of which, when the second connecting element (44) is inserted into the recess (22) in the LED circuit board (14), the fixing element (26) can be rotated as far as a predefinable position.

9. Reflector arrangement (10) according to one of the preceding claims,
wherein the reflector element (46) has spacer elements (54) with a predefined length in the longitudinal direction, so that, when the first connecting element (50) of the reflector element (46) is inserted into the depression (32) in the upper side (28) of the fixing element (26), and, when the second connecting element (44) of the fixing element (26) is inserted into the recess (22) in the LED circuit board (14), the spacer elements (54) contact the LED circuit board (14).

10. Reflector arrangement (10) according to one of the preceding claims,
wherein the reflector element (46) comprises snap-in elements (56) which, when the reflector element (46) is arranged on the LED circuit board (14), are designed to snap in under contact surfaces of the base (12) which are at least partly arranged along the holding area (16) of the LED circuit board (14).

## Revendications

1. Système réflecteur (10) comportant un corps de base (12), au moins une carte imprimée à LED (14) et au moins un élément réflecteur (46), le corps de base (12) présentant une zone de réception (16) pour loger l'au moins une carte imprimée à LED (14), l'au moins une carte imprimée à LED (14) étant agencée dans la zone de réception (16) du corps de base (12) et présentant au moins un évidement (22), l'élément réflecteur (46) comportant un premier élément de liaison (50), **caractérisé en ce que** le système réflecteur (10) comprend au moins un élément de fixation (26), l'élément de fixation (26) comprenant une face supérieure (28) et une face inférieure (30), la face supérieure (28) étant agencée à une distance de la face inférieure (30), la face inférieure (30) comportant un deuxième élément de liaison (44) qui présente une extension longitudinale dans un sens d'extension longitudinale allant de la face supérieure (28) vers la face inférieure (30), la face supérieure (28) de l'élément de fixation (26) présentant un creux (32) dans le sens d'extension longitudinale, le deuxième élément de liaison (44) de l'élément de fixation (26) et l'évidement (22) de la carte imprimée à LED (14) étant réalisés de telle sorte que le deuxième élément de liaison (44) peut être introduit dans l'évidement (22) de la carte imprimée à LED (14), de sorte que la face inférieure (30) de l'élément de fixation (26) peut être mise en contact avec la carte imprimée à LED (14), et le creux (32) de la face supérieure (28) de l'élément de fixation (26) et le premier élément de liaison (50) de l'élément réflecteur (46) étant réalisés de telle sorte que le premier élément de liaison (50) de l'élément réflecteur (46) peut être introduit dans le creux (32) de la face supérieure (28) de l'élément de fixation (26), de telle sorte que l'élément réflecteur (46) peut être mis en contact avec la face supérieure (28) de l'élément de fixation (26).

2. Système réflecteur (10) selon la revendication 1, le deuxième élément de liaison (44) présentant, sur la face inférieure (30) de l'élément de fixation (26), une forme de base cylindrique et l'évidement (22) de la carte imprimée à LED (14) ayant une forme cylindrique telle que l'élément de fixation (26) avec le deuxième élément de liaison (44) peut, lorsqu'il est introduit dans l'évidement (22) de la carte imprimée à LED (14), tourner autour d'un axe allant dans le sens d'extension longitudinale.

3. Système réflecteur (10) selon l'une des revendications précédentes, l'élément de fixation (26) présentant une face extérieure (36) qui est agencée entre la face supérieure (28) et la face inférieure (30) de l'élément de fixation (26), une pièce de liaison en forme de crochet (38) étant agencée sur la face extérieure (36), le corps de base (12) présentant au moins un élément complémentaire (20) qui est réalisé de telle sorte que la pièce de liaison en forme de crochet (38) peut être accrochée dans l'élément complémentaire (20).

4. Système réflecteur (10) selon l'une des revendications précédentes, l'élément complémentaire (20) étant agencé au moins en partie le long de la zone de réception (16) de la carte imprimée à LED (14), l'élément complémentaire (20) étant réalisé de telle sorte que la pièce de liaison en forme de crochet (38) de l'élément de fixation (26) peut, lorsque le deuxième élément de liaison (44) de la face inférieure (30) de l'élément de fixation (26) est introduit dans l'évidement (22) de la carte imprimée à LED (14), être accroché dans l'élément complémentaire (20) par rotation de l'élément de fixation (26) autour de l'axe allant dans le sens de l'extension longitudinale.

5. Système réflecteur (10) selon l'une des revendications précédentes, le creux (32) de la face supérieure (28) de l'élément de fixation (26) et le premier élément de liaison (50) de l'élément réflecteur (46) étant réalisés sous une forme ronde dans une section perpendiculaire au sens de l'extension longitudinale, de sorte que l'élément réflecteur (46) peut, lorsque l'élément de liaison (50) est introduit dans le creux (32), tourner autour d'un axe allant en direction du sens de l'extension longitudinale.

6. Système réflecteur (10) selon l'une des revendications précédentes, la face supérieure (28) de l'élément de fixation (26) présentant une rainure rectiligne (34) perpendiculaire au sens de l'extension longitudinale et l'élément réflecteur (46) présentant un élément de patin (52) qui est réalisé de telle sorte qu'il peut être introduit dans la rainure (34).

7. Système réflecteur (10) selon l'une des revendications précédentes, la face extérieure (36) de l'élément de fixation (26) étant, au moins dans une zone, réalisé en tant que surface plane (42), de telle sorte que l'élément de fixation (26) peut, au moyen de cette surface plane (42), être orienté sur l'élément complémentaire (20) du corps de base (12).

8. Système réflecteur selon l'une des revendications précédentes, sur la face extérieure (36) de l'élément de fixation (26) étant agencé un élément de butée (40) au moyen duquel l'élément de fixation (26) peut tourner jusque dans une position prédéterminable lorsque le deuxième élément de liaison (44) est introduit dans l'évidement (22) de la carte imprimée à LED (14).

9. Système réflecteur (10) selon l'une des revendications précédentes, l'élément réflecteur (46) comportant des éléments d'écartement (54) ayant une longueur prédéterminée dans le sens de l'extension longitudinale, de sorte que, lorsque le premier élément de liaison (50) de l'élément réflecteur (46) est introduit dans le creux (32) de la face supérieure (28) de l'élément de fixation (26) et que le deuxième élément de liaison (44) de l'élément de fixation (26) est introduit dans l'évidement (22) de la carte imprimée à LED (14), les éléments d'écartement (54) sont en contact avec la carte imprimée à LED (14).

10. Système réflecteur (10) selon l'une des revendications précédentes, l'élément réflecteur (46) comprenant des éléments d'encliquetage (56) qui sont réalisés pour s'encliqueter, lorsque l'élément réflecteur (46) est agencé sur la carte imprimée à LED (14), sous des surfaces d'appui du corps de bases (12), qui sont situées au moins en partie le long de la zone de réception (16) de la carte imprimée à LED (14).
